Europäisches Patentamt

**European Patent Office**

Office européen des brevets

(11) Publication number : **0 469 611 B1**

(12) **EUROPEAN PATENT SPECIFICATION**

(45) Date of publication of patent specification :
05.04.95 Bulletin 95/14

(51) Int. Cl.⁶ : **H01L 29/73,** H01L 21/329,
H01L 29/417, H01L 29/76

(21) Application number : **91112961.7**

(22) Date of filing : **01.08.91**

(54) **Tunnel injection semiconductor devices and its manufacturing process.**

(30) Priority : **03.08.90 JP 205005/90**

(43) Date of publication of application :
**05.02.92 Bulletin 92/06**

(45) Publication of the grant of the patent :
**05.04.95 Bulletin 95/14**

(84) Designated Contracting States :
**DE FR GB IT**

(56) References cited :
**EP-A- 0 348 916
DE-A- 4 001 390
US-A- 4 400 710
IBM TECHNICAL DISCLOSURE BULLETIN,
vol. 31, no. 12, May 1989, pages 287-288,
Armonk, NY, US; "SILICIDE INTERFACE
MONITOR"
PATENT ABSTRACTS OF JAPAN, vol. 9, no.
169 (E-328)(1892), 13 July 1985
PATENT ABSTRACTS OF JAPAN, vol.
12,no.162 (E-609)(3009), 17 May 1988**

(73) Proprietor : **HITACHI, LTD.
6, Kanda Surugadai 4-chome
Chiyoda-ku, Tokyo 101 (JP)**

(72) Inventor : **Honma, Hideo
2-20-1-407, Mizuki-cho
Hitachi-shi, Ibaraki-ken (JP)**
Inventor : **Kawakami, Sumio
1207-4, Sanzai-cho
Hitachiota-shi, Ibaraki-ken (JP)**
Inventor : **Nagano, Takahiro
7-10-10, Kanesawa-cho
Hitachi-shi, Ibaraki-ken (JP)**

(74) Representative : **Patentanwälte Beetz - Timpe -
Siegfried Schmitt-Fumian - Mayr
Steinsdorfstrasse 10
D-80538 München (DE)**

EP 0 469 611 B1

## Description

BACKGROUND OF THE INVENTION

The present invention

The present invention relates to a structure of a semiconductor device suitable for enhancing integration density and high performance, and its manufacturing process, more particularly to those suitable as a tunnel injection type semiconductor device.

In accordance with the increasing capacities in VLSIs typified by DRAMs, it is required for the semiconductor devices to be implemented therein to have a highly dense integration structure. A number of problems, however, are arising with such efforts to increase integration densities as follows.

For example, regarding the MOSFET which is one of the typical semiconductor devices, further reduction in dimension is considered difficult to realize because of the reasons of: (1) variations in characteristics due to the short channel effect, (2) decrease in withstand voltage due to the parasitic bipolar effects, (3) possible threshold voltage variation due to the statistical fluctuation of impurities, (4) an increase in a leakage current due to the increased impurity concentration, and so on.

As one of means to solve such problems as mentioned above, there has been proposed such a semiconductor device, for example, as described in JP-A-62-274775, wherein a tunneling current flowing through the Schottky barrier junction is controlled by means as set forth therein.

The aforementioned semiconductor device based on the prior art tunneling current control techniques has an unsymmetrical structure rather difficult to fabricate in which the source is formed of metal while the drain is formed of $n^+$-semiconductor layer. In addition, there arise such problems that because a connection wiring from said $n^+$-layer must be extended through the contact hole to the electrode wiring layer, a carrier path is lengthened accordingly, and that contact resistance added up between the $n^+$-layer and the wiring causes the parasitic resistance to increase, thereby decreasing the drain (tunneling) current.

Semiconductor devices which control the tunnel current with a gate have been known as disclosed in DE-A-4001390, US-A4400710 and in the document IBM Technical Disclosure Bulletin, Vol. 31, 1989, No. 12, pp. 287-288.

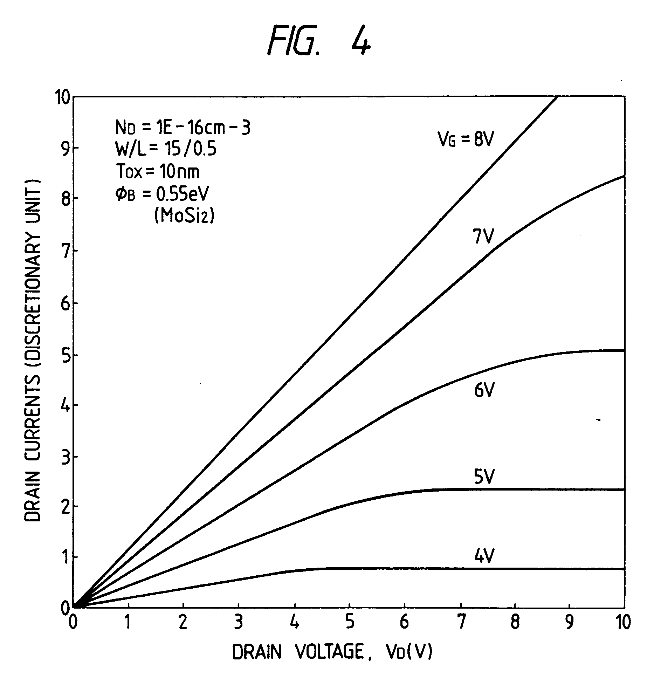

Particularly, DE-A- 4 001 390 discloses a semiconductor device according to the preamble of the claim. In this semiconductor device shown in Fig. 4 of DE-A-4001390, on one surface of an n-type first semiconductor layer are formed an n-type second semiconductor layer having an impurity concentration higher than that of the first semiconductor layer, a p-type third semiconductor layer which is disposed apart from the second semiconductor layer and has an impurity concentration higher than that of the first semiconductor layer, a drain region made of a metal in ohmic contact with the second semiconductor layer, in the first semiconductor layer is formed a source region made of a metal via a Schottky barrier junction and being in ohmic contact with the third semiconductor layer, on the source region is formed a source electrode, on the drain region is formed a drain electrode, and a control electrode is formed on the drain region, on the source region and on the first semiconductor layer located therebetween via an insulating film.

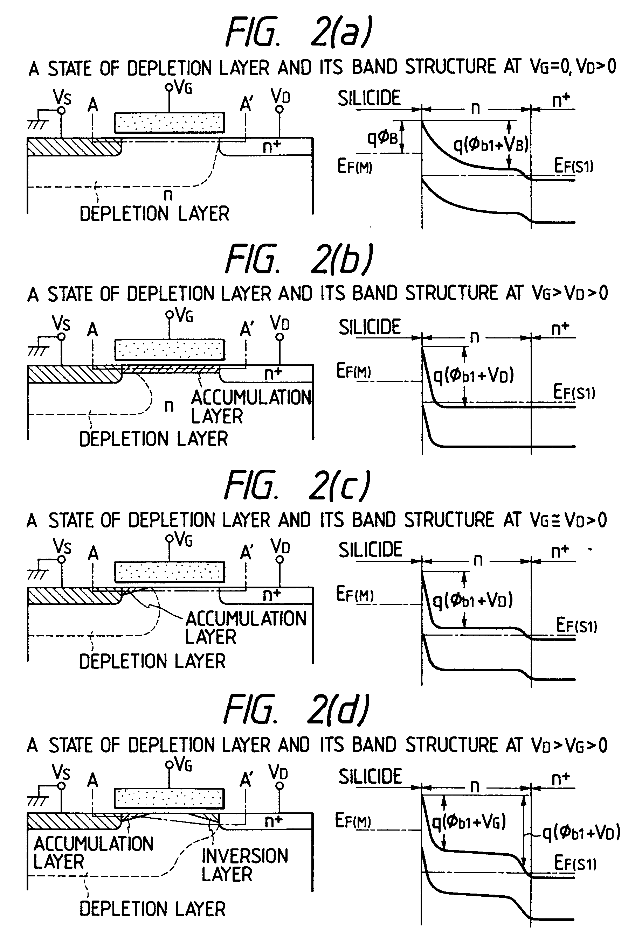

In a semiconductor device shown in Fig. 2B of US-A-4400710, an n-type layer to serve as a channel region is formed on an $n^+$-type substrate to serve as a drain region, a $p^+$-type layer to serve as a control region is formed in the surface of the n-type layer with a space, and a drain electrode, a source electrode and a control electrode are formed on the $n^+$-type substrate, n-type layer and $p^+$-type layer, respectively.

In a semiconductor device shown in Fig. 2 of the IBM Technical Disclosure Bulletin, on the top surface of a first $p^-$-type semiconductor layer are formed a second $n^+$-type semiconductor layer having an impurity concentration higher than that of the first semiconductor layer and a third $p^+$-type semiconductor layer that is disposed apart from the second semiconductor layer and has an impurity concentration higher than that of the first semiconductor layer, and a source region made of a metal compound is formed adjacently to the second semiconductor layer, a drain region made of a metal compound is formed adjacently to the third semiconductor layer, a source electrode is formed on the source region, a drain electrode is formed on the drain region, and a control electrode is formed via an insulating film on the first semiconductor layer between the second and third semiconductor layers at a place apart from the drain region and the source region. In the semiconductor device of this constitution, since the control electrode is provided at a place apart from the source region, the tunnel current flows through a pn junction formed between the first and second semiconductor layers, and the second semiconductor layer and the source region are in ohmic contact with each other.

## SUMMARY OF THE INVENTION

The object of the present invention is to provide a tunnel injection type semiconductor device which is suited for high-speed switching use by suppressing the leakage current while the semiconductor device is off and by increasing the tunnel current while the semiconductor device is on.

In order to achieve the above object, the present invention provides a tunnel injection type semiconductor device comprising a first semiconductor layer of a first conductivity type, a second semiconductor layer of the first conductivity type which is adjacent to the first semiconductor layer and has an impurity concentration higher than that of the first semiconductor layer, a drain region made of a metal or a metal compound and being adjacent to the second semiconductor layer, a source region made of a metal or a metal compound and being adjacent to the first semiconductor layer, a source electrode provided on the source region, a drain electrode provided on the drain region, and a control electrode provided above an insulating film, said control electrode being located on the drain region, on the source region, and on the first semiconductor layer located therebetween, wherein a third semiconductor layer is formed on the whole surface between the first semiconductor layer and the source region, having a second conductivity type and a low impurity concentration and forming a Schottky barrier junction relative to the source region.

In the thus constituted semiconductor device of the present invention, since the third semiconductor layer is formed on the whole surface between the first semiconductor layer and the source region, the third semiconductor layer of the second conductivity type having a low impurity concentration to form a Schottky barrier junction relative to the source region, it is possible to decrease the leakage current while the device is off by means of the pn junction formed between the first semiconductor layer and the third semiconductor layer, to increase the tunnel current while the device is on by means of the Schottky barrier junction formed between the source region and the third semiconductor layer, and, hence, to accomplish the above-mentioned object .

The other objects and functions of the present invention will be appreciated from the descriptions of embodiments to be set forth in the following.

## BRIEF DESCRIPTION OF THE DRAWINGS

| Fig. 1 | shows cross-section and plane views of an n-type tunnel injection transistor device; |
| --- | --- |
| Figs. 2 and 3 | explain the principle of operation of the transistor shown in Fig. 1; |
| Fig. 4 | shows the static characteristics of the transistor; |
| Fig. 5 | shows the relationships between Schottky barrier heights and drain current/leakage currents; |
| Fig. 6, 8 though 10 | show cross-section views of other n-type tunnel injection transistor devices; |
| Fig. 9 | shows a cross-section view of an n-type tunnel injection transistor device according to the present invention; |
| Fig. 7 | shows exemplary steps of fabrication of a semiconductor device with cross-sectional views of the elements; |
| Fig. 11 | shows a cross-sectional view of the n-type and p-type tunnel injection transistors constituting an inverter circuit, and its equivalent circuit. |

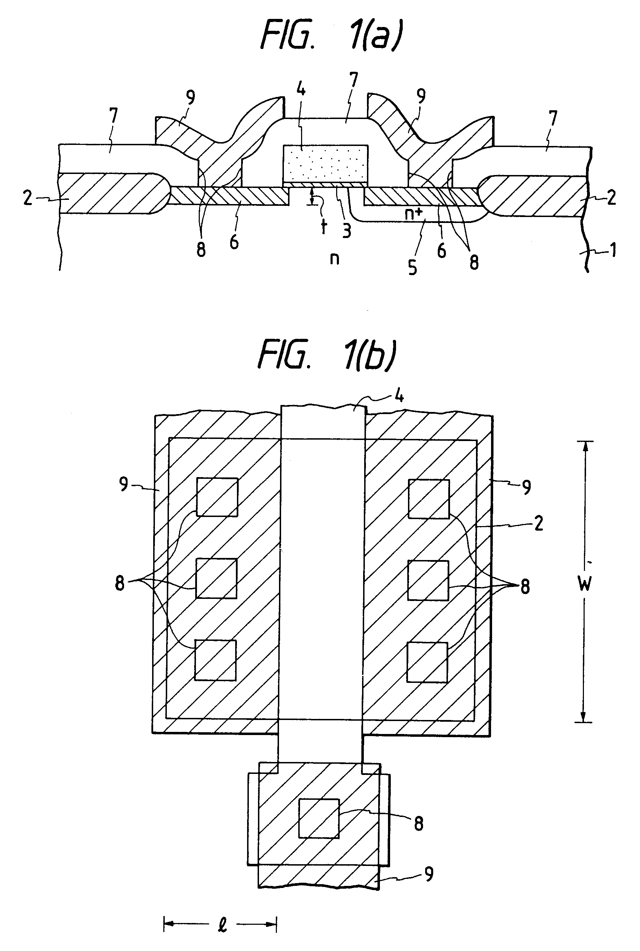

Fig.1 (a) is a cross-sectional view of an example of an n-type tunnel injection transistor, which comprises: a low impurity concentration n-type semiconductor substrate 1, a field oxide film $(SiO_2)$2 which defines an active region, a gate oxide film $(SiO_2)$3, a gate electrode 4 made of $n^+$-polycrystalline silicon, titanium silicide $(TiSi_2)$6 formed symmetrically at the source and drain sides buried in said substrate 1 partially overlapping with the gate electrode thereupon, a high impurity concentration $n^+$-type semiconductor layer 5 surrounding the $TiSi_2$6 at the drain side, an insulating layer $(BPSG/SiO_2)$7, and an electrode wiring layer 9 connected through a contact through hole 8. Fig.1 (b) shows a plane view of Fig.1 (a).

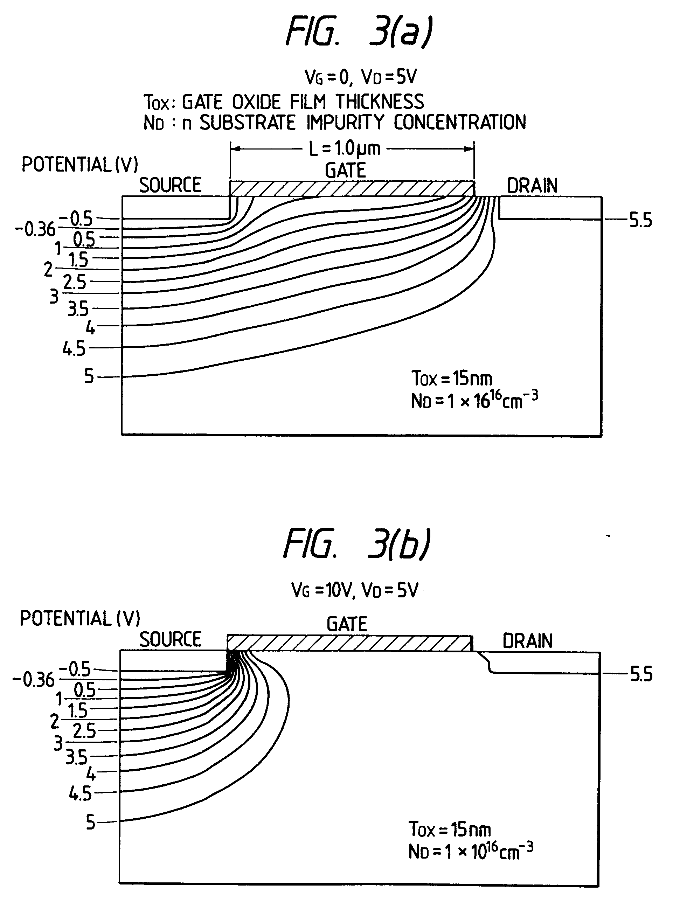

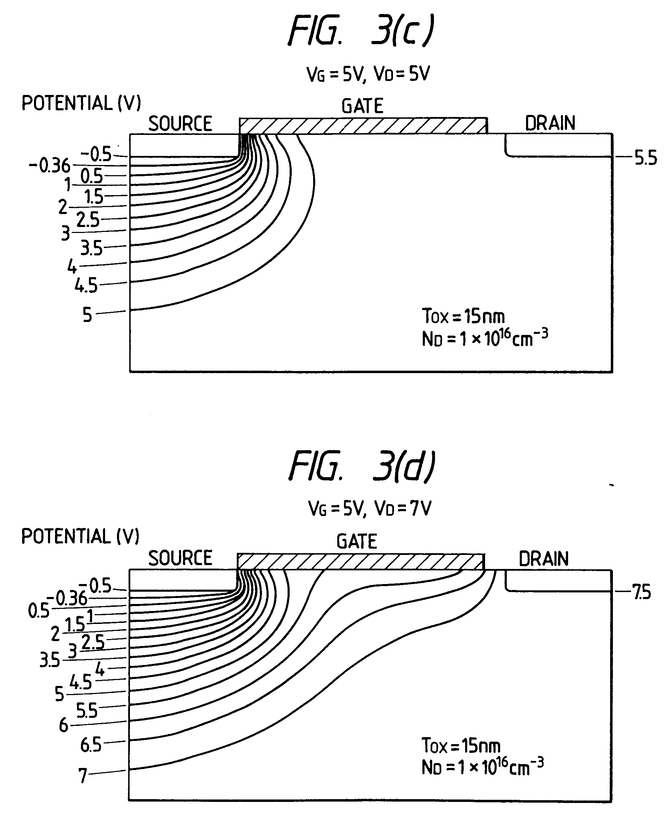

By referring to Figs.2 and 3, the principle of operation of the transistor will be described below. Because $TiSi_2$ at the drain side in Fig.1 is disposed in contact with the $n^+$-layer, the expansion of a depletion layer thereof is minimized so as to form so-called an ohmic contact therebetween permitting carriers freely to pass through as they are. For simplification' sake, silicides at the drain are omitted in Figs.2 and 3. Fig.2 illustrates extension of depletion layers in the device under various bias conditions, and associated band structures along lines A-A′. Fig.3 shows the result of calculation of equi-potential lines between the source and drain under various bias conditions.

Fig.2 (a) and Fig.3 (a) are the results obtained under a bias condition that $V_G=0$, and a drain voltage $V_D>0$. When no voltage is applied to the gate, a depletion layer expands according to a sum of a diffusion potential $\phi_{bi}$ and $V_D$ along the Schottky barrier junction. A width of the depletion layer (Schottky barrier width) is sufficiently large and its potential is distributed uniformly between the source and drain. Thereby, there occurs no tunnel injection except for a slight amount of a leakage current flowing due to the reverse direction characteristics of a Schottky barrier diode.

In Fig.2 (b) and Fig.3 (b), bias conditions were differentiated from the cases (a), by applying a larger positive potential to $V_G$ than $V_D$ in such a relation as $V_G > V_D > 0$. Because of the potential of $V_G$, a depletion layer band in the n-substrate directly beneath the gate is bent, and an accumulation layer of electrons is formed uniformly between the source and drain. As a result, as is obvious from the potential distribution, the depletion layer of the Schottky barrier junction is contracted toward the source front, thereby permitting electron injection from the source into the n-substrate and permitting a tunneling current to flow from the drain to the source.

Fig.2 (c) and Fig.3 (c) show cases where $V_G$ and $V_D$ are approximately the same. At approximately the same potential of $V_G$ and $V_D$, potential in the n-substrate at the drain side is pulled up to $V_D$, thereby the accumulation layer diminishes in the vicinity of the drain. However, because potential of the n-substrate at the source end is constantly fixed at the source potential (0) irrespective of $V_D$, there remains in the vicinity of the source end an accumulation layer of electrons having a density corresponding to $V_G$, thus permitting the tunneling current to flow therethrough.

Fig.2 (d) and Fig.3 (d) represent conditions wherein $V_D$ was increased from the case (c) to such that $V_D \geqq V_G \geqq 0$. Under such bias conditions, a p-type inversion layer is formed directly beneath the gate in the vicinity of the drain, thus, permitting the depletion layer again to expand up to the drain front. As observed obviously from the potential distribution, however, a difference in potentials, i.e., $V_D - V_G$ is shared between the accumulation layer end and the drain end. Namely, for $V_D > V_G$, potentials at the ends of the accumulation layers are fixed approximately at $V_G$, and a tunneling current is saturated by a difference in potentials when $V_D$ exceeds $V_G$.

As hereinabove described, according to the tunnel injection transistor of Fig. 1, current saturation characteristics having smaller values than that of other prior art MOSFETs are obtained as shown in $V_D$-$I_D$ characteristics in Fig.4.

As can be appreciated from Fig.1, because $TiSi_2$ members 6 are provided symmetrically in the source and drain, partially buried underneath the gate electrode 4, it is readily possible for carriers (electrons) injected from the source to reach the low resistance $TiSi_2$6 at the drain side only passing through $n^+$-layer 5 having a sufficiently narrow width. Further, because there exists almost no contact resistance between $TiSi_2$6 in the drain and the electrode wiring layer 9, a contact resistance between the electrode wiring layer 9 and the $n^+$-layer 5 is determined substantially by a contact resistance which exists between the $TiSi_2$6 of the drain and the $n^+$-layer 5, a contact area therebetween being larger, but that value is sufficiently small. Thereby, a parasitic resistance between the drain and source is capable of being reduced, thus increasing the drain (tunneling) current. Still further, because $TiSi_2$ members 6 are provided symmetrically in the source and drain, at least the process of its manufacture is substantially simplified.

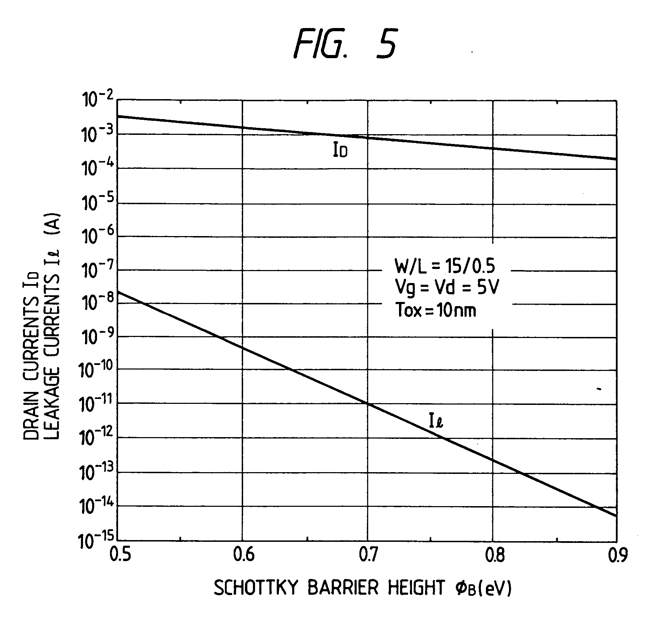

On the other hand, in order to obtain a larger drain current, it is necessary to employ such material for the source that has a smaller value in the Schottky barrier height $\phi_B$. In this case, however, there arises a problem that a leakage current also increases. Fig.5 shows relationships between drain current $I_D$ and $\phi_B$, and leakage current $I_1$ and $\phi_B$, respectively, under the conditions that gate width $W = 15\mu m$, gate length $L = 0.5\mu m$, gate oxide film thickness $T_{OX} = 10nm$, and $V_G = V_D = 5V$. By decreasing $\phi_B$, $I_D$ can be increased. The leakage current $I_1$, however, increases remarkably because of the properties proper to the Schottky barrier diode. As has been described previously, a drain (tunneling) current is injected into an extremely small area in which an accumulation layer and the metallic member meet each other. Thereby, at least the bottom surface of $TiSi_2$6 at the source side in Fig.2 is an unnecessary region in view of the principle of device operation. Should the unnecessary region be removed, the leakage current I1 could be reduced, because the leakage current is proportional to a contact area of $TiSi_2$6 of the source.

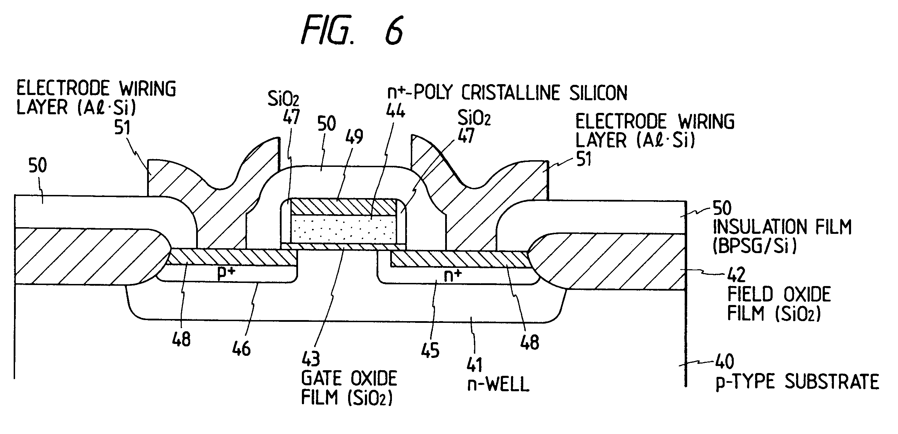

Another example shown in Fig.6 is contemplated based on the idea hereinabove.

Fig.6 shows a cross-sectional view of an n-type tunnel injection transistor, which comprises: a p-type substrate 40; a low impurity concentration n-type well region 41; a field oxide film $(SiO_2)$42 which defines an active region; a gate electrode made of layers of a gate oxide film $(SiO_2)$43, an $n^+$-polycrystalline silicon 44 and titanium silicide $(TiSi_2)$49; a thin film insulation layer $(SiO_2)$47 formed on the side periphery of the gate; titanium silicide $TiSi_2$48 formed symmetrically in the source and drain within said well region 41, portions of which buried beneath the gate electrode overlaid partially; a high impurity concentration $n^+$-type semiconductor layer 45 formed surrounding the periphery of $TiSi_2$48 at the drain; a high impurity concentration $p^+$-type semiconductor layer 46 formed surrounding the bottom surface of $TiSi_2$48 at the source; an insulating layer $(BPSG/SiO_2)$50; and an electrode wiring layer 51 for extending connection of the source/drain or the gate to the outside. Because the bottom surface of $TiSi_2$48 at the source is surrounded by the high impurity concentration $p^+$-type semiconductor layer 46 in this transistor, the bottom surface portion of the source provides a p-n junction instead of a Schottky barrier junction to the n-well region 41. The p-n junction being a small number carrier element, is capable of reducing its leakage current by several orders of magnitude than the Schottky barrier junction. Thereby an effect equivalent to having removed the bottom portion of $TiSi_2 48$ at the source is obtained, thus permitting the use of materials as a source electrode, which have a smaller $\phi_B$ value, while minimizing the leakage current.

When a plurality of such transistors formed on the same substrate constitutes a switching circuit, its switching speed may be delayed due to a parasitic capacitance induced in their drains. For example, because the drain in Fig.6 has the same potential as that of the n-well region 41, the drain is subjected to a large parasitic capacitance induced between the n-well region 41 and the p-type substrate 40, thereby delaying its switching speed.

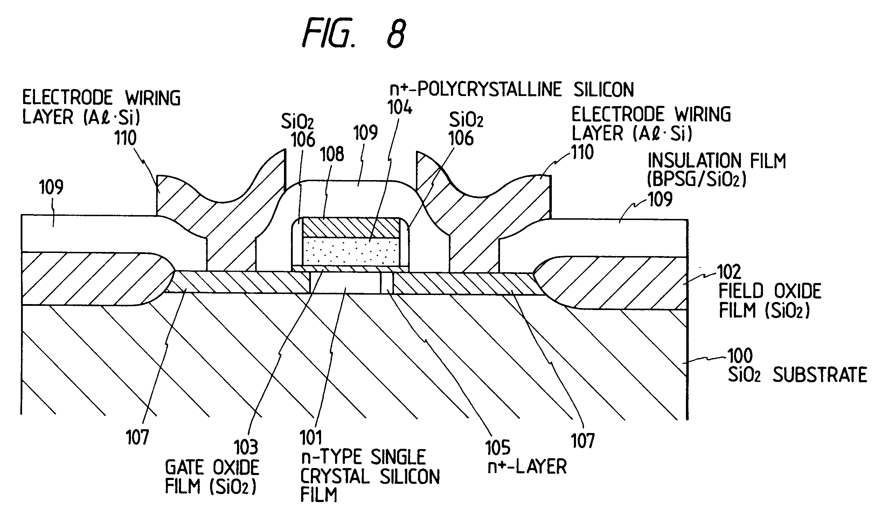

Fig.8 shows an SOI type n-type tunnel injection transistor contemplated to solve the hereinabove problems. It comprises in combination: an n-type single crystal silicon layer 101 formed on the surface of a $SiO_2$ substrate 100; a field oxide film $(SiO_2)102$ which defines an active region; a gate electrode made up of layers of a gate oxide film $(SiO_2)103$, an $n^+$-polycrystalline silicon 104 and titanium silicide $(TiS_2)108$; a thin film insulation layer $(SiO_2)106$ formed on the side periphery of the gate; titanium silicide $(TiSi)_2 107$ formed symmetrically at the source and gate in said n-type silicon film 101, partially buried underneath the gate electrode, and the bottom surfaces being in contact with said $SiO_2$ substrate 100; a high impurity concentration $n^+$-type semiconductor layer 105 formed between $TiSi_2 107$ at the drain and the n-type silicon layer 101; an insulating layer $(BPSG/SiO_2)109$; and an electrode wiring layer 110 for extending connections of the source/drain or the gate to the outside. Because at least the bottom surfaces of $TiSi_2 107$ at the source and drain are in direct contact with the $SiO_2$ substrate 100, a parasitic capacitance in the drain is negligibly small. The parasitic capacitance at the source is reduced likewise. In addition, because the bottom portion of $TiSi_2 107$ at the source side forms no Schottky barrier junction, the leakage current is substantially reduced. As a result, the switching speed of a switching circuit or the like can be further enhanced. Still further, because the n-type silicon film 101 in this transistor as described above is at the same potential as the drain, there occurs no kink phenomena or the like problems as have been observed in the prior art SOI type MOSFETs due to the floating of its well potential. It is preferable for said $n^+$-layer to have a concentration at its surface of approximately $10^{20}cm^{-3}$, and for the $p^+$-layer to have about 10 times a larger impurity concentration as that of the substrate, through $10^{20}cm^{-3}$.

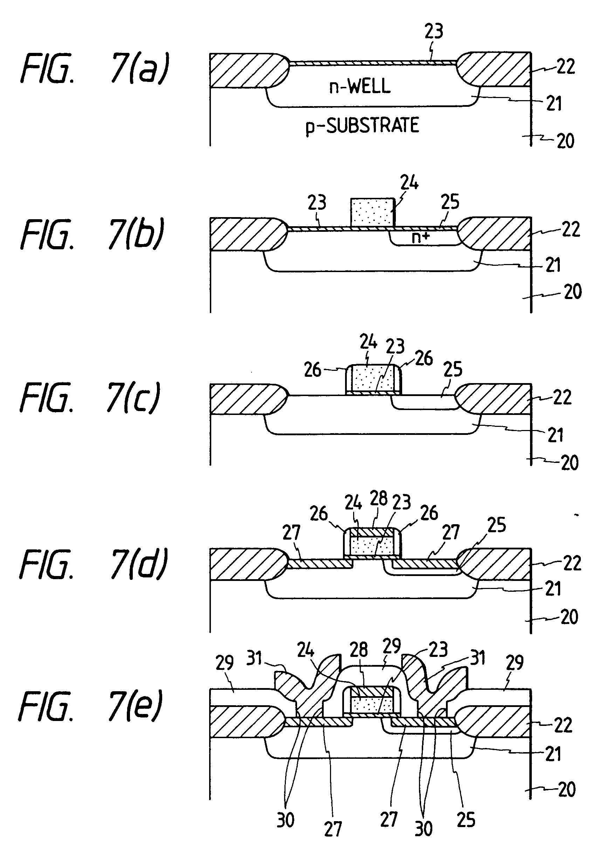

Fig.7 shows cross-sectional views of an n-type tunnel injection transistor similar to that of Fig.1 according to its fabrication steps. An n-well region 21 having a concentration of approximately $10^{16}cm^{-3}$ is formed in a prescribed region on a p-type silicon substrate 20 by diffusing phosphorus (P) atoms therein. Referring to Fig.7-A, a field oxide film $(SiO_2)22$ is formed surrounding the n-well region 21 by the selective oxidation technique, then, a gate oxide film 23 composed of $SiO_2$ having a 8nm thickness is formed on the surface of said n-well region. Next, a gate electrode 24 is formed through deposition of $n^+$-polycrystalline silicon over the entire surface by CVD techniques, followed by photo-etching techniques to form the same into a desired shape. Then, in reference to Fig.7-B, after masking a photo-resist, arsenic (As) ions are injected into the drain region at 20 KeV, $5\times10^{15}cm^{-2}$, then heat treatment are made at 900°C for 20 minutes to form an $n^+$-diffusion layer 25. Subsequently, referring to Fig.7-C, a $SiO_2$ film is deposited on the entire surface by the CVD techniques, then said $SiO_2$ film is etched off by reactive-ion-etching (RIE) techniques to form a thin $SiO_2$ film 26 on the side wall of the gate electrode 24, and at the same time exposing the surfaces of the source/drain and the gate electrode as well. Next, with reference to Fig.7-D, a Mo film is sputter-deposited on the entire surface to a thickness of 50 nm, then heat treatment is made at 600°C for 20 sec. by lamp annealing to form $MoSi_2$ portions 27, 28 only in said exposed silicon surfaces. Unreacted Mo is removed with nitric acid. Next referring to Fig.7-E, after depositing a double layer insulation film 29 made of $BPSG/SiO_2$ by CVD techniques, a contact through-hole 30 is formed reaching the $MoSi_2$ films at the source/drain and the gate by photo-etching techniques. Finally, after depositing an Al·Si film over the entire surface to a thickness of 500 nm by sputtering, said Al·Si film is formed into a desired shape by photo-etching techniques to form an electrode wiring layer 31, thus accomplishing an n-type tunnel injection transistor.

This exemplary transistor is capable of obtaining an increased drain (tunneling) current because of a parasitic capacitance sufficiently reduced between the source and drain as has been explained with regard to Fig.1.

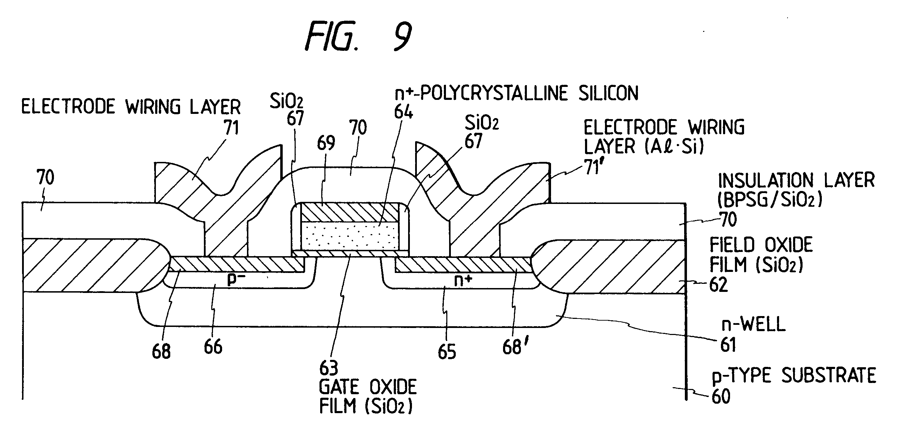

Fig.9 shows a cross-sectional view of an n-type tunnel injection transistor according to an embodiment of the present invention wherein a leakage current is controlled in a likewise manner as in Fig.6. The embodiment comprises: a p-type substrate 60; a low impurity concentration n-type well region 61; a field oxide film $(SiO_2)62$ which defines an active region; a three-layered gate electrode made up of a gate oxide film $(SiO_2)63$, an $n^+$-polycrystalline silicon 44 and vanadium silicide $(VSi_2)69$; a thin film insulation layer $(SiO_2)67$ formed on the side periphery of the gate; $VSi_2 68,68'$ formed symmetrically in the source and drain within said well region 61, partially overlaid by the gate electrode; a high impurity concentration $n^+$-type semiconductor layer 65 formed so as to surround the periphery of $VSi_2$68' at the drain side; a low impurity concentration p-type semiconductor layer 66 formed so as to surround the bottom and the side surface of $VSi_2$68 at the source side; an insulation layer (BPSG/$SiO_2$)70; and an electrode wiring layer 71,71' for extending connection of the source/drain and the gate to the outside. In this exemplary transistor, the bottom and side surface of $VSi_2$68 at the source are surrounded by the low impurity concentration p-type semiconductor layer 66. By setting the impurity level of said p-type semiconductor layer 66 appropriately such that only a leakage current in the reverse direction is reduced without affecting forward characteristics ($V_F$) of the Schottky barrier junction, the leakage current is capable of being reduced remarkably without lowering the drain (tunneling) current.

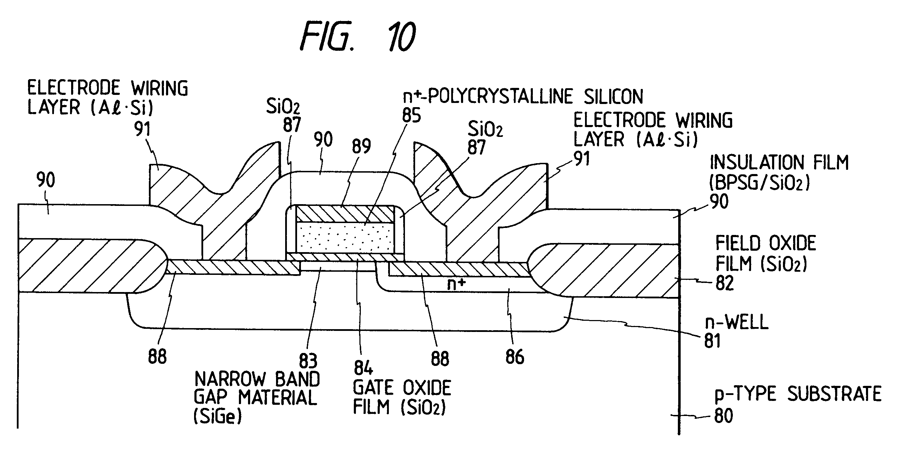

Fig.10 shows a cross-sectional view of an example of an n-type tunnel injection transistor wherein its leakage current is suppressed in a likewise manner as in Fig.6. It comprises: a p-type substrate 80; a low impurity concentration n-type well region 81; a narrow band gap member 83 composed of $Si_{0.55}Ge_{0.45}$ formed on the surface of said n-type well region 81; a field oxide film ($SiO_2$) 82 which defines an active region; a three-layered gate electrode composed of a gate oxide film ($SiO_2$) 84, an $n^+$-polycrystalline silicon 85 and a platinum silicide (PtSi) 89; a thin film insulation layer ($SiO_2$) 87 formed on the side periphery of the gate; PtSi 88 formed symmetrically in the source and drain within said well region 81, portion of which overlapping with the gate electrode thereupon; a high impurity concentration $n^+$-type semiconductor layer 86 formed so as to surround the periphery of PtSi 88 at the drain side; an insulation layer (BPSG/$SiO_2$)90; and an electrode wiring layer 91 for extending connection of the source/drain and the gate to the outside. This embodiment transistor is provided with a narrow band gap member 83 on the surface of the n-type well region 81. The band gap Eg of this $Si_{0.55}Ge_{0.45}$ is approximately 0.8eV, which is smaller by about 0.3eV than that of Si. Because of the above reason, $\phi_B$ at a Schottky barrier junction between the source PtSi and the $Si_{0.55}Ge_{0.45}$ becomes approximately 0.55eV, which is smaller by approximately 0.3eV than $\phi_B$=0.85eV at a Schottky barrier junction formed between the bottom portion of the source and the same. Namely, because $\phi_B$ is made smaller only at the portion of the source end through which the tunneling current is injected, only the drain current is affected to be increased while suppressing the leakage current to the minimum.

The embodiment hereinbefore described is related to the n-type tunnel injection transistors. A p-type tunnel injection transistor, however, may be readily obtained, for example, in Fig.6, by rendering each of the substrate 40, well region 41, high impurity concentration semiconductor layer 45, and high impurity concentration semiconductor layer 46 an opposite conductivity type. In case of providing both n-type and p-type transistors on the same substrate where a large drain current is in demand for both, it is advantageous to utilize a Schottky barrier material having a half value (approximately 0.55eV) of the band gap $\phi_B$ of silicon. In this regard, it is preferable to employ $MoSi_2$, $VSi_2$, V, $TiSi_2$ or the like. Still further, although in Fig.8, the SOI type tunnel injection transistor has been described, the same effect is capable of being obtained by replacing the $SiO_2$ substrate with a p-type semiconductor substrate.

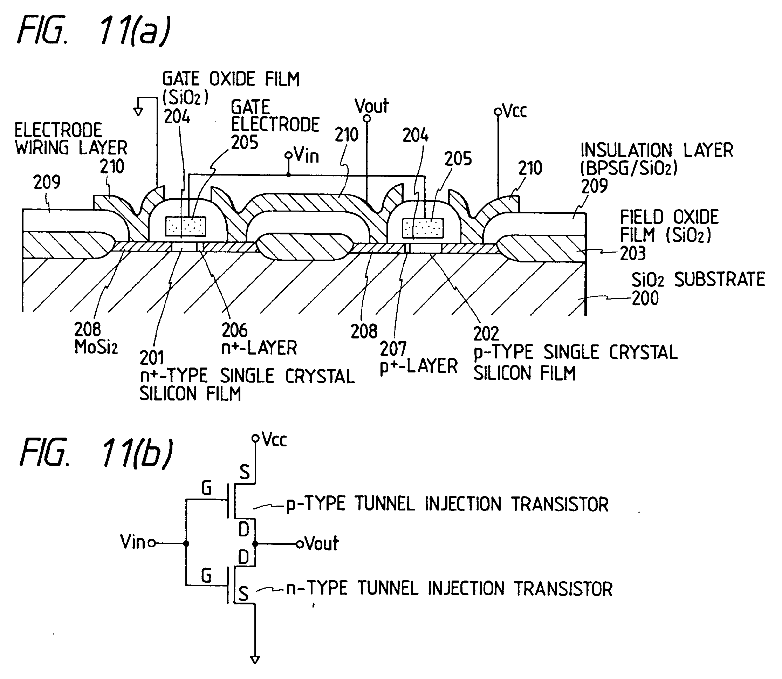

Fig.11 shows a cross-sectional view of the above-mentioned n-type and p-type tunnel injection transistors integrated on the same substrate constituting an inverter circuit, and its equivalent circuit. This embodiment comprises in combination: an n-type single crystal silicon layer 201 and a p-type single crystal layer 202, each formed on the surface of a $SiO_2$ substrate 200; a field oxide film ($SiO_2$)203 which defines active regions and isolates n-and p-elements by being interposed therebetween; a gate oxide film ($SiO_2$)204; a gate electrode 205; $MoSi_2$ films 208 formed symmetrically at the source and drain sides within said n-and p-type silicon layers 201 and 202, partially overlain by the gate electrode, and the respective bottom surfaces of which disposed in contact with said $SiO_2$ substrate 200; a high impurity concentration $n^+$-type semiconductor layer 206 and a high concentration $p^+$-type semiconductor layer 207, the former provided between $MoSi_2$ film 208 at the drain and said silicon layer 201, the latter provided between $MoSi_2$ film 208 at the drain and said silicon layer 202; an insulation layer (BPSG/$SiO_2$)209; and an electrode wiring layer 210 for extending connections of respective source/drain and the gate of each element to the outside. This inverter circuit functions likewise a CMOS inverter according to the prior art MOSFETs; whereby a source voltage Vcc is applied to the source of the p-type transistor and an input voltage $V_{in}$ is applied to the common gate, then an output voltage Vout is obtained. The tunnel injection transistors constituting this device have a small current saturation with respect to the drain voltage, thereby they are permitted to flow a large drain current, and are capable of performing at extremely high speeds because of a small enough parasitic capacitance induced along respective elements between the source and drain.

As hereinabove described, because the transistor according to the present invention is capable of being provided with the same circuit configuration as by the prior art MOSFETS, it can be applied to various types of CMOS logic circuits, and also to BiCMOS logic circuits and memory circuits in combination with bipolar transistors.

As has been described in the embodiments hereinbefore, a device having a small leakage current is capable of being implemented according to the present invention even when the submicron technologies are further enhanced, and the gate length is reduced to less than 0.2μm, furthermore less than 0.1μm.

More specifically, a leakage current (reverse current) in this exemplary device is expressed by the following equation (1).

$$I_1 = SA^* T^2 exp(-q\phi_B/kT) \quad (1)$$

where,

S:          Schottky barrier junction area
A*:        Richardson constant (258.9 Acm$^{-2}$k$^{-2}$)
T:          Absolute temperature (K)
q:          Electron charge (1.62x10$^{19}$ coulomb)
k:          Boltzmann constant (1.38x10$^{-23}$ joule/K)
$\phi_B$:       Schottky barrier height (eV)

As shown in Fig.1, by indicating the gate width as W, gate LOCOS (device isolation region) distance as 1, and silicide thickness as t, then the Schottky barrier junction area S can be expressed by the sum of the bottom surface component (W·l) and the side component (W·t), i.e., S=W·l+W·t. In operative devices where W=15μm, t=0.05μm, and gate length = 0.2μm, then 1 becomes approximately 0.8μm, or when gate length = 0.1μm, 1 becomes approximately 0.6μm, thus, respective leakage currents in each device are given as follows.

1) For the structure of Fig.1 with a gate length of 0.2μm;

$$I_1 = 1.78x10^{-9}(A),$$

and with a gate length of 0.1μm;

$$I_1 = 1.36x10^{-9}(A)$$

2) For the structures of Figs.6 and 8, irrespective of gate length:

$$I_1 = 1.05x10^{-10}(A)$$

3) For the structure of Fig.10 with a SiGe layer thickness of 0.05μm, irrespective of gate length:

$$I_1 = 1.05x10^{-10}(A)$$

Hereinbefore, respective examples and an embodiment have been explained as using various materials having different $\phi_B$. In order to compare the leakage currents on the same standard, MoSi$_2$($\phi_B$=0.55eV) has been utilized here for reference, except for the case of Fig.10 where it is intended to utilize a higher Schottky barrier height, thus, employing PtSi($\phi_B$=0.85eV) for comparison.

As are obvious from the above comparisons, the cases of Figs.6, 8 and 10 are capable of reducing their leakage currents to approximately one tenth that of Fig.1. All of these results are resulted from the elimination of the bottom components(W·l) at the Schottky barrier junctions. Namely, in the cases of Figs.6, 8 and 10, the leakage currents depend entirely on the thickness of metal or metal compound electrodes.

According to the present invention, a preferable structure for semiconductor devices suitable for enhancing higher density integration.

Further, according to the present invention, a semiconductor device having increased switching speeds is capable of being obtained.

**Claims**

1. A tunnel injection type semiconductor device comprising a first semiconductor layer (61) having a first conductivity type, a second semiconductor layer (65) having the first conductivity type, being adjacent to the first semiconductor layer (61) and having an impurity concentration higher than that of the first semiconductor layer (61), a third semiconductor layer (66) having a second conductivity type and a low impurity concentration, a drain region (68') adjacent to the second semiconductor layer (65), a source region (68) adjacent to said first semiconductor layer (61), a source electrode (71) provided on the source region (68), a drain electrode (71') provided on the drain region (68'), and a control electrode (64, 69) provided above an insulating film (63), said control electrode (64, 69) being located on the drain region (68'), on the source region (68) and on the first semiconductor layer (61) located therebetween,
**characterized** in that
the source region (68) and the drain region (68') are made of a metal or a metal compound and that the third semiconductor layer (66) is formed on the whole surface between the first semiconductor layer (61) and the source region (68), said third semiconductor layer (66) forming a Schottky barrier junction relative to the source region (68).

## EP 0 469 611 B1

**Patentansprüche**

1. Tunnelhalbleiterbauelement, welches umfaßt:

   eine erste Halbleiterschicht (61) mit einem ersten Leitfähigkeitstypus, eine zweite Halbleiterschicht (65) mit dem ersten Leitfähigkeitstypus, die an die erste Halbleiterschicht (61) angrenzt und eine höhere Dotierungskonzentration als die erste Halbleiterschicht (61) besitzt, eine dritte Halbleiterschicht (66) mit einem zweiten Leitfähigkeitstypus und einer niedrigen Dotierungskonzentration, einem Drain-Bereich (68'), der an die zweite Halbleiterschicht (65) angrenzt, einem Source-Bereich (68), der an die erste Halbleiterschicht (61) angrenzt, einer Source-Elektrode (71), die auf dem Source-Bereich (68) vorgesehen ist, einer Drain-Elektrode (71'), die auf dem Drain-Bereich (68') vorgesehen ist, und einer Steuerelektrode (64, 69), die oberhalb eines Isolierfilms (63) vorgesehen und auf dem DrainBereich (68'), dem Source-Bereich (68) und der dazwischenliegenden ersten Halbleiterschicht (61) angeordnet ist,

   **dadurch gekennzeichnet, daß**

   der Source-Bereich (68) und der Drain-Bereich (68') aus Metall oder einer Metallverbindung hergestellt sind und daß die dritte Halbleiterschicht (66) auf der gesamten Oberfläche zwischen der ersten Halbleiterschicht (61) und dem Source-Bereich (68) gebildet ist und einen Schottky-Übergang in bezug auf den Source-Bereich (68) bildet.

**Revendications**

1. Dispositif à semiconducteurs du type à injection par effet tunnel, comprenant une première couche semiconductrice (61) possédant un premier type de conductivité, une seconde couche semiconductrice (65) possédant un premier type de conductivité et qui est adjacente à la première couche semiconductrice (61) et possède une concentration en impureté supérieure à celle de la première couche semiconductrice (61), une troisième couche semiconductrice (66) possédant un second type de conductivité et une faible concentration en impureté, une région de drain (68') adjacente à la seconde région semiconductrice (65), une région de source (68) adjacente à ladite première couche semiconductrice (61), une électrode de source (71) prévue sur la région de source (68), une électrode de drain (71') prévue sur la région de drain (68'), et une électrode de commande (64,69) disposée au-dessus d'une pellicule isolante (63), ladite électrode de commande (64,69) étant située sur la région de drain (68'), sur la région de source (68) et sur la première couche semiconductrice (61) située entre elles,

   caractérisé en ce que

   la région de source (68) et la région de drain (68') sont réalisées en un métal ou en un composé métallique, et que la troisiième couche semiconductrice (66) est formée sur l'ensemble de la surface entre la première couche semiconductrice (61) et la région de source (68), ladite troisième couche semiconductrice (66) formant une jonction de barrière de Schottky par rapport à la région de source (68).

8

## FIG. 1(a)

## FIG. 1(b)

FIG. 2(a)

A STATE OF DEPLETION LAYER AND ITS BAND STRUCTURE AT $V_G=0$, $V_D>0$

FIG. 2(b)

A STATE OF DEPLETION LAYER AND ITS BAND STRUCTURE AT $V_G>V_D>0$

FIG. 2(c)

A STATE OF DEPLETION LAYER AND ITS BAND STRUCTURE AT $V_G \cong V_D>0$

FIG. 2(d)

A STATE OF DEPLETION LAYER AND ITS BAND STRUCTURE AT $V_D>V_G>0$

10

# FIG. 3(a)

$V_G = 0$, $V_D = 5V$

Tox: GATE OXIDE FILM THICKNESS
N_D : n SUBSTRATE IMPURITY CONCENTRATION

# FIG. 3(b)

$V_G = 10V$, $V_D = 5V$

FIG. 3(c)

FIG. 3(d)

## FIG. 4

$N_D = 1E - 16 cm - 3$
$W/L = 15/0.5$
$T_{OX} = 10 nm$
$\Phi_B = 0.55 eV$
(MoSi2)

$V_G = 8V$

7V

6V

5V

4V

DRAIN CURRENTS (DISCRETIONARY UNIT)

DRAIN VOLTAGE, $V_D(V)$

FIG. 5

FIG. 6

FIG. 7(a)

FIG. 7(b)

FIG. 7(c)

FIG. 7(d)

FIG. 7(e)

# FIG. 8

ELECTRODE WIRING LAYER (Aℓ·Si) 110

ELECTRODE WIRING LAYER (Aℓ·Si) 110

n+-POLYCRYSTALLINE SILICON 104

$SiO_2$ 106

$SiO_2$ 106

108

109

109

109

INSULATION FILM (BPSG/$SiO_2$)

102 FIELD OXIDE FILM ($SiO_2$)

100 $SiO_2$ SUBSTRATE

107

103 GATE OXIDE FILM ($SiO_2$)

101 n-TYPE SINGLE CRYSTAL SILICON FILM

105 n+-LAYER

107

EP 0 469 611 B1

# FIG. 9

ELECTRODE WIRING LAYER 71

SiO₂ 67

69 70

n⁺-POLYCRYSTALLINE SILICON 64

SiO₂ 67

ELECTRODE WIRING LAYER (Aℓ·Si) 71′

INSULATION LAYER (BPSG/SiO₂) 70

FIELD OXIDE FILM (SiO₂) 62

n-WELL 61

p-TYPE SUBSTRATE 60

70

p⁻

n⁺

68 66

63 GATE OXIDE FILM (SiO₂)

65 68′

EP 0 469 611 B1

FIG. 10

ELECTRODE WIRING LAYER (Aℓ·Si) 91

SiO₂ 87

n⁺-POLYCRYSTALLINE SILICON 85

SiO₂ 87

ELECTRODE WIRING LAYER (Aℓ·Si) 91

INSULATION FILM (BPSG/SiO₂) 90

FIELD OXIDE FILM (SiO₂) 82

n-WELL 81

p-TYPE SUBSTRATE 80

90

90

89

n⁺

88

83 NARROW BAND GAP MATERIAL (SiGe)

84 GATE OXIDE FILM (SiO₂)

88

86

EP 0 469 611 B1

## FIG. 11(a)

GATE OXIDE FILM (SiO₂) 204
GATE ELECTRODE 205
ELECTRODE WIRING LAYER 210
ELECTRODE 209
INSULATION LAYER (BPSG/SiO₂) 209
FIELD OXIDE FILM (SiO₂) 203
SiO₂ SUBSTRATE 200
p-TYPE SINGLE CRYSTAL SILICON FILM 202
p⁺-LAYER 207
n⁺-LAYER 206
n⁺-TYPE SINGLE CRYSTAL SILICON FILM 201
MoSi₂ 208

Vcc
Vout
Vin
210
205
204
208

## FIG. 11(b)

Vcc
p-TYPE TUNNEL INJECTION TRANSISTOR
Vout
n-TYPE TUNNEL INJECTION TRANSISTOR
Vin
S  G  D  D  G  S